# EUROPEAN PATENT SPECIFICATION

(11) **EP 1 411 144 B1**
(45) Date of publication and mention of the grant of the patent: **06.10.2010**
(21) Application number: 02738851.1
(22) Date of filing: 28.06.2002
(51) Int. Cl.: C23C 16/26, C23C 16/48, C23C 16/455, C23C 16/04, B82B 1/00, B82B 3/00

(54) **METHOD FOR FORMING ULTRA-HIGH STRENGTH ELASTIC DIAMOND LIKE CARBON STRUCTURE**
VERFAHREN ZUR HERSTELLUNG EINER HOCHFESTEN ELASTISCHEN DIAMANTARTIGEN KOHLENSTOFFSTRUKTUR
PROCEDE DE FORMAGE DE STRUCTURE DE CARBONE DIAMANTOIDE ELASTIQUE ULTRA-RESISTANTE

(30) Priority: 29.06.2001 JP 2001197885
(43) Date of publication of application: 21.04.2004
(73) Proprietor: NEC Corporation, Minato-ku Tokyo 108-8001 (JP); SII Nano Technology Inc., Chiba-shi, Chiba (JP)
(72) Inventor: FUJITA, Jun-ichi c/o NEC CORPORATION, Minato-ku, Tokyo 108-8001 (JP); ISHIDA, Masahiko c/o NEC CORPORATION, Minato-ku, Tokyo 108-8001 (JP); OCHIAI, Yukinori c/o NEC CORPORATION, Minato-ku, Tokyo 108-8001 (JP); MATSUI, Shinji, Himeji-shi, Hyogo 670-0083 (JP); KAITO, Takashi c/o SEIKO INSTRUMENTS INC., Chiba-shi, Chiba 261-8507 (JP)
(74) Representative: Wenzel & Kalkoff
(86) International application number: PCT/JP2002/006546
(87) International publication number: WO 2003/002779

(56) References cited:
- EP-A1- 0 710 057
- WO-A1-02/44079
- JP-A- 10 163 201
- JP-A- 2001 107 252
- JP-A- 2001 107 252
- JP-B1- 2 967 198
- US-A- 5 135 808
- US-A- 6 086 962
- SHINJI MATSUI ET AL: "Three-dimensional nanostructure fabrication by focused-ion-beam chemical vapor deposition" JOURNAL OF VACUUM SCIENCE AND TECHNOLOGY: PART B, AVS / AIP, MELVILLE, NEW YORK, NY, US, vol. 18, no. 6, 2000, pages 3181-3184, XP002956386 ISSN: 1071-1023
- T. MORI, Y. NAMBA: "Hard diamondlike carbon films deposited by ionized deposition of methane gas" JOURNAL OF VACCUM SCIENCE TECHNOLOGY, PART A, vol. 1, no. 1, 1983, pages 23-27, XP002455513 New York, USA
- SHINJI MATSUI ET AL.: 'Three-dimensional nanostructure fabrication by focused-ion-beam chemical vapor deposition' J. VAC. SCI. TECHNOL. B vol. 18, no. 6, 2000, pages 3181 - 3184, XP002956386

## Description

### Technical Field

The present invention relates to a method for forming elastic diamond-like carbon having ultra high strength, and more specifically relates to the method for forming elastic diamond-like carbon having ultra high strength of which the hardness can be controlled in a relatively wide range.

### Background Art

A thin film or a fine structure formed by diamond-like carbon (hereinafter referred to as DLC) is superior in its mechanical characteristics such as abrasion resistance and hardness (Young's modulus), and is considerably important for industrial application.

A DLC film formed by using the CVD method, for example, is extensively utilized as a surface protection film for magnetic storage media such as a magnetic head and a hard disc, and is an indispensable technical element for the current electronics age.

A method for obtaining the DLC film is relatively well-known in which source gas prepared from aromatic hydrocarbon is decomposed by means of a surface excitation reaction with use of rays, electron beam and ion beam.

Currently, the DLC decomposition product is prepared by an electron and ion excitation reaction using electron beam and ion beam. This technique is significantly important for processing nano-order material because the dimension of the decomposition product can be controlled in several nanometers as described, for example, in J. Vac. Sci. & Technol., 2000 (vol.6) p.3181-3184 and further a three- dimensional hollow structure is possibly formed and in JP 2001 107252 A.

The nano-order-technique for forming the three-dimensional structure with the DLC may be applied to mechanical devices of nano-scale (NEMS) and bio-electronics. Further applications are expected to medical fields, astronautical engineering and future generation electronics such as a quantal operation computer.

The hardness (Young's modulus), the important fundamental physical property of the DLC, is a considerably important parameter when the applications to actual devices such as a filter utilizing resonance and a nano-mechanical device are concerned. When the DLC close to natural diamond is realized, its industrial application range is amazingly broad.

The artificially-prepared DLC film heretofore reported (CVD method) is utilized as an abrasion-resistant protection film of a magnetic head and a magnetic storage medium. The Young's modulus thereof is about 600 GPa which is about half 1220 GPa of a natural diamond crystal having the highest hardness among those naturally occurring on the earth. The hardness of a nanotube currently attracting public attention is about 1,000 GPa which is close to that of natural diamond.

### Disclosure of Invention

Accordingly, an object of the present invention is to provide elastic DLC with ultra high strength having a hardness close to diamond and a three-dimensional arbitrary shape, different from the conventional CVD diamond shaped in a thin film.

A method of forming the elastic DLC with ultra high strength in accordance with the present invention is characterized by the steps of claim 1.

In accordance with the present invention, a high performance nano-structure can be easily obtained because the hardness of the DLC structure can be controlled with relatively high degree of freedom, and the strength or the hardness of the DLC structure can be controlled in a significantly broad range from a usual metal to that close to natural diamond.

The above and other objects, embodiments and advantages of the present invention will be apparent in accordance with the following description.

### Brief Description of Drawings

Fig.1 is a diagram exemplifying the method of forming an elastic DLC having ultra high strength in accordance with the present invention.
Fig.2 is a top plan view showing a method of supplying gas usable in the present invention.
Fig.3 is a side view showing another method of supplying gas usable in the present invention.
Fig.4 is a diagram showing the relation between the gas supply and the beam irradiation.
Fig.5 is a diagram exemplifying the elastic DLC having the ultra high strength formed in accordance with the present invention.
Fig.6 is a diagram exemplifying another elastic DLC having the ultra high strength formed in accordance with the present invention.
Fig.7 is a graph showing the relation between growth rate and Young's modulus when the elastic DLC having ultra high strength is formed in Example of the present invention.

### Best Mode for Implementing Invention

The present inventors have developed, as a result of researches, a technique in which the Young's modulus of a DLC pillar having a diameter of about 80 nm and a length of 20 µ m is controlled to reach a 1000 GPa level near to that of natural diamond by growing the DLC while controlling equilibrium conditions of the decomposition reaction for forming the DLC and the sputtering impact by ions.

The present invention provides a technique of forming the elastic DLC structure having ultra high strength by using a focused ion beam apparatus having a gas nozzle for maintaining a partial gas pressure of source gas such as phenanthrene (C₁₄H₁₀) and pyrene (C₁₆H₁₀) to be high locally near the substrate and a structure for confining the gas on the substrate, and further by controlling the amount of the focused ion beam current from 0.1 to 10 pA, and by controlling the amount of the focused ion beam current in the above range and the growth rate of the DLC film in the range from 1.2 to 2.0 µm/min.

Ordinarily, the important index is the growth rate in the reaction for forming the decomposition product using the focused ion beam apparatus and hydrocarbon gas such as aromatic hydrocarbon gas.

Generally, in the reaction of forming the decomposition product by using ion irradiation, the main process is not a direct reaction between the ions and the source gas but a reaction in which secondary electrons generated by ion irradiation decompose the gas absorbed on the surface.

The effective beam diameter of the focused ion beam becomes from about 5 to 7 nm because of the upgrade of the current focused ion beam apparatus.

When such thin beam is irradiated on the substrate or the decomposition product, the beam penetrates in the depth of several tens of nanometers or extends also by several tens of nanometers due to forward scattering and stops in the substrate or the decomposition product in case of the ions of about 30 keV.

During the reaction, secondary electrons from several eV to several keV are emitted through an Auger process, an atom's outer shell excitation process and an inelastic scattering process. The reaction cross section of the lower-energy secondary electron is large, and the source gas adsorbed on the surface is decomposed to form the DLC in the non-equilibrium process.

Eventually, the chemical equilibrium of the above reaction for forming the decomposition product is attained by the rate of forming the adsorption layer on the DLC growth surface with the supply gas and the amount of the secondary electrons. In other words, the DLC production reaction becomes predominant by increasing the gas supply together with the increase of the ion beam amount, thereby elevating the growth rate.

However, it is experimentally revealed that the Young's modulus of the product becomes lower when the growth rate is too rapid.

The Young's modulus also becomes lower when the amount of the irradiated ion beam per unit time is smaller (corresponding to the case the ion current is smaller) even if the growth rate is unchanged.

The appropriate control of the growth rate and the ion current is required to increase the Young's modulus of the DLC pillars. The substrate is ion-sputtered when the gas supply is stopped and the ion beam is irradiated.

It is conjectured that the hardness of the DLC product be increased in the decomposition reaction of the source gas by means of the ion beam because the simultaneous occurrence of the reaction of the source gas and the ion sputtering leads to the formation of amorphous DLC and the hammering into the DLC.

Accordingly, in the method of the present invention, the DLC product having the Young's modulus at the same level as that of the natural diamond can be prepared by controlling the Young's modulus of the DLC product by means of providing the appropriate amount of the ion current and the appropriate growth rate.

In the present invention, the irradiation amount of the focused ion beam is controlled with the amount of the ion beam current from 0.1 to 10 pA. The control within the above range makes the hardness of the DLC product prepared after the appropriate growth rate to be higher than that of the DLC product prepared by the conventional focused ion beam irradiation. It is difficult to obtain the practically stable ion beam, and to realize the sufficient hardness of the carbon product at the irradiation amount below 0.1 pA. The focusing of the beam becomes worse due to the Coulomb's repulsion impairing the resolution of the fine structure over 10 pA. Both ranges are not preferable.

When the irradiation amount of the focused ion beam is controlled with the amount of the ion current from 0.1 to 10 pA, the growth rate of the DLC structure is from 1.2 to 2.0 µm/min.

Though also depending on other conditions, the growth rate of the DLC structure about from 1.2 to 2.0 µ m/min. makes the Young's modulus of the DLC structure to be 700 to 900 GP which is near to that of the natural diamond.

In the present invention, the higher pressure of the source gas may be preferable depending on the case. In such a case, a plurality of gas nozzles is positioned toward the central position to which the ion beam is irradiated, thereby increasing the partial gas pressure on the surface of the substrate to effectively control the local partial gas pressure on the substrate.

However, the higher partial pressure of the source gas is not necessarily efficient depending on the amount of the ion beam current to be utilized.

In such a case, the partial gas pressure around the substrate can be made uniform by surrounding the irradiated section with a gas reflection wall and using a single gas nozzle without increasing the gas pressure.

The beam irradiation can be conducted in accordance with interval timing in which the irradiations and the pausings are repeated in the focused ion beam apparatus.

The efficiency of the present invention is improved when the plurality of the gas nozzles is disposed toward the irradiation position of the focused ion beam and the distance between the front edge of the gas nozzles and the substrate is adjusted to be 500 µm or less.

In the present invention, the gas reflection wall having a height the same level as a distance between the gas nozzle and the substrate may be mounted around the position to which the focused ion beam is irradiated. The gas reflection wall may have one or more wall surfaces which extend in a region having a similar length to the above distance.

Then, the formation of the DLC structure by using the actual focused ion beam will be described. The source gas is introduced simultaneously with the irradiation of the focused ion beam to the substrate on which the DLC structure is mounted. Aromatic hydrocarbon such as phenanthrene and pyrene is desirably used as source gas. The DLC structure, for example, the DLC pillar is grown on the position where the ion beam is irradiated. At this stage, by scanning the irradiated position in a direction of X-Y, a three-dimensional structure having a shape such as a beaker, a bellows and a wine glass can be freely fabricated.

The prominent characteristic of the DLC structure-forming technique by using the ion beam is the capability of fabricating the three-dimensional structure. The main reason thereof is that the penetration depth or the diffusion length of the ion beam into or in the substance is relatively short. This means that the region in which secondary electrons are generated by means of ion excitation is narrow.

Consequently, the decomposition reaction of the surface adsorption layer takes place in the range of several tens nanometers around the point where the ion beam is irradiated, thereby growing the nano-scaled pillar.

When the irradiated position of the ion beam is gradually moved in the radial direction from the center of the pillar, the place of the secondary electron generation also moves accordingly.

With the move of the irradiated position of the beam, the secondary electron generation starts on the sidewall of the pillar, and the DLC grows on the sidewall direction side (moving direction side) by means of the decomposition reaction on the sidewall.

In other words, the overhung shape can be formed by using the single ion beam. The substance grown on the sidewall neither reaches nor gets in contact with the substrate because the narrowness of the generation region of the secondary electrons restricts the growth region on the sidewall in several tens nanometers.

When the rotation is provided to the ion beam by the scanning in the X-Y direction, a shape such as a coil spring can be obtained provided that the growth rate in the vertical (Z) direction is sufficiently high such that the growing front edge is not in contact with the growing section directly below the growing front edge.

Another shape such as a bellows and a beaker can be grown when the rotation rate of the beam is high, the growth per rotation is continuous in the Z-direction and the rotation radius of the beam is periodically modulated. The combination between the growth of the rotated elliptic structure formed by the beam rotation and the pillar growth enables the formation of a wineglass shape.

The CVD technique using the focused ion beam has a high degree of freedom in connection with the control of such a shape to be formed. The hardness of any section of the structure can be freely controlled by applying the present invention.

The uniformity of the partial pressure of the supply gas is generally required to be high in an FIB (Focused Ion Beam) CVD apparatus usable in the present invention. This is because the uniform growth rate in all the directions cannot be obtained when the rate of forming the surface adsorption layer is not uniform in full circumference. The excellent three-dimensional structure can be obtained by mounting, for example, a plurality of gas supply nozzles in the apparatus.

The uniformity of the partial gas pressure can be inexpensively controlled by using another method. In this method, a gas reflection wall having a height which is the same level as a distance between the gas nozzle and the substrate is mounted opposing to the gas nozzle, and the degree of freedom for designing the apparatus is elevated because the single gas nozzle is used. The reflection wall may be formed as one-surface wall opposing to the gas nozzle, or two- or three-surface wall having one or two right angles embracing the gas nozzle, or a curved surface wall.

The actual control of the partial gas pressure is rather difficult because the typical partial gas pressure in the apparatus for achieving the above growth rate is in the order of 1.33 x 10⁻⁸ KPa (10⁻⁷ torr). This is the same level as that of the residual gas in the apparatus. Of course, the partial gas pressure in the vicinity of the substrate is predicted to be higher than the above value. The determination of the correct value is difficult, and practically and essentially rather meaningless.

Under these circumstances, the growth control method using time interval is used for obtaining the proper partial gas pressure with excellent controllability. In accordance with the essence of the present invention, the hardness of the DLC structure is determined by the appropriate amount of the surface adsorbate and the appropriate amount of the irradiated ion beam corresponding to the amount of the surface adsorbate. The hardness of the DLC pillar is controllable by periodically controlling the time length of the ion beam irradiation and, if necessary, also the gas supply when the partial gas pressure is low.

Examples of actual structures will be illustrated to which the above apparatus configuration and the conditions of the ion irradiation and the pillar growth rate are applied.

The bellows is assumedly used as parts of a micro-machine for combining micro-parts at a position where bending and stretching movements are required after the formation on the substrate followed by its separation. The important function is the expansion and contraction of the bellows and its durability.

That is, the bellows is required to be firmly bonded at its edge section and to be flexibly expanded and contracted at its expanding and contracting section. Such control of the hardness depending on the position can be easily attained by applying the growth technique of the present invention.

Similar functions are required in nano-tweezers which may be fabricated by applying DLC pillar fabrication.

For example, by inserting a soft section into the DLC pillar, the DLC structure having two rigid ends and the flexible section at the required position can be formed continuously.

### [Embodiments]

Embodiments of the present invention will be described in detail referring to the drawings.

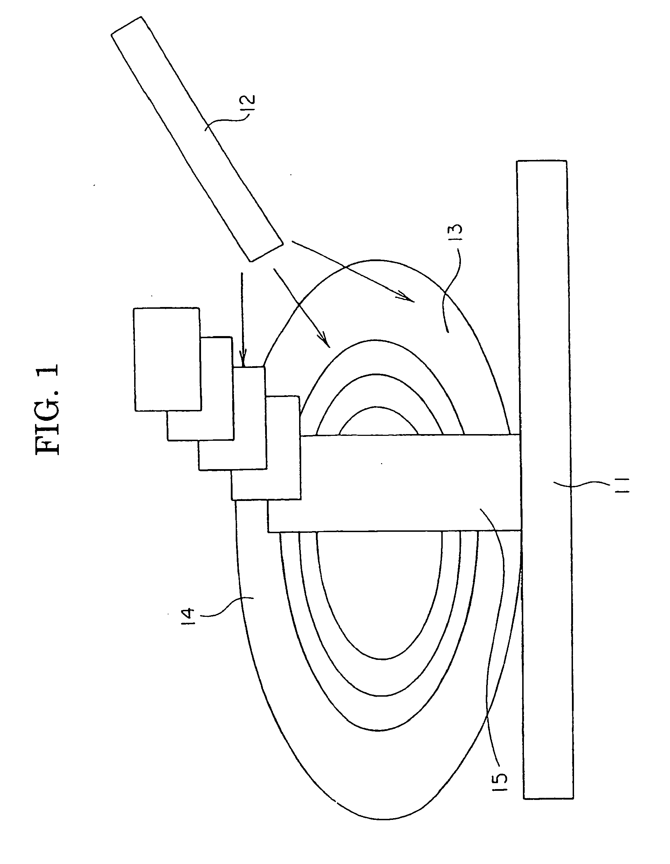

Fig.1 is a diagram exemplifying a method of forming elastic DLC having ultra high strength in accordance with the present invention.

In the exemplified method, Ga⁺ ion beam 14 is irradiated while source gas such as phenanthrene is supplied from a source gas nozzle 12 to a substrate 11, thereby forming a gas atmosphere 13. In this manner, a DLC pillar 15 is formed and grown on a position of the substrate 11 where the ion beam is irradiated.

The DLC pillar having the appropriate hardness can be obtained by controlling an amount of the ion beam irradiated to the growing DLC pillar by means of ion beam current from 0.1 to 10 pA.

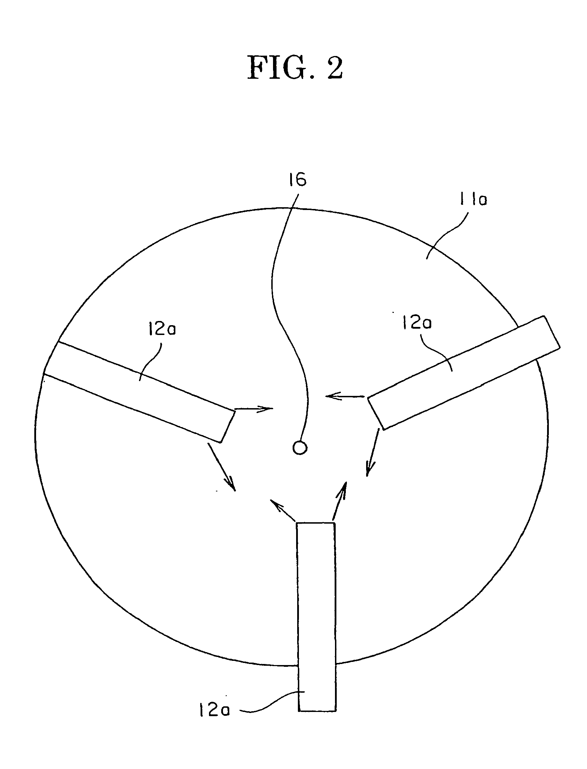

Fig.2 shows the positional relation between a substrate 11a and gas nozzles 12a for uniformly supplying gas. When the ion beam is irradiated in this configuration, the ion beam is uniformly irradiated on an irradiated position 16 or on the surface of the growing DLC pillar on the substrate to provide an excellent three-dimensional structure.

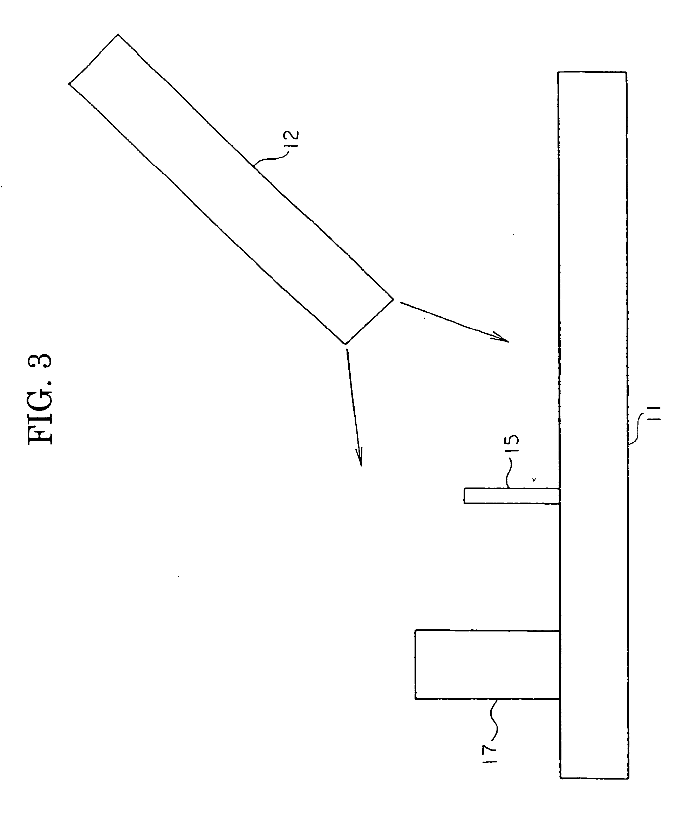

Fig.3 is a diagram showing a method of simply and inexpensively controlling the uniformity of a gas partial pressure.

In the illustrated embodiment, the substrate 11, the gas nozzle 12 and the DLC pillar 15 having the same configuration as that of Fig.1 are arranged, and a gas reflection wall 17 is mounted on the substrate on the opposite side of the source gas nozzle 12 with respect to the DLC pillar 15. The gas reflection wall 17 has a function of uniformly supplying the source gas to the DLC pillar 15 after the source gas is reflected toward the DLC pillar 15, thereby reducing wasting of source gas.

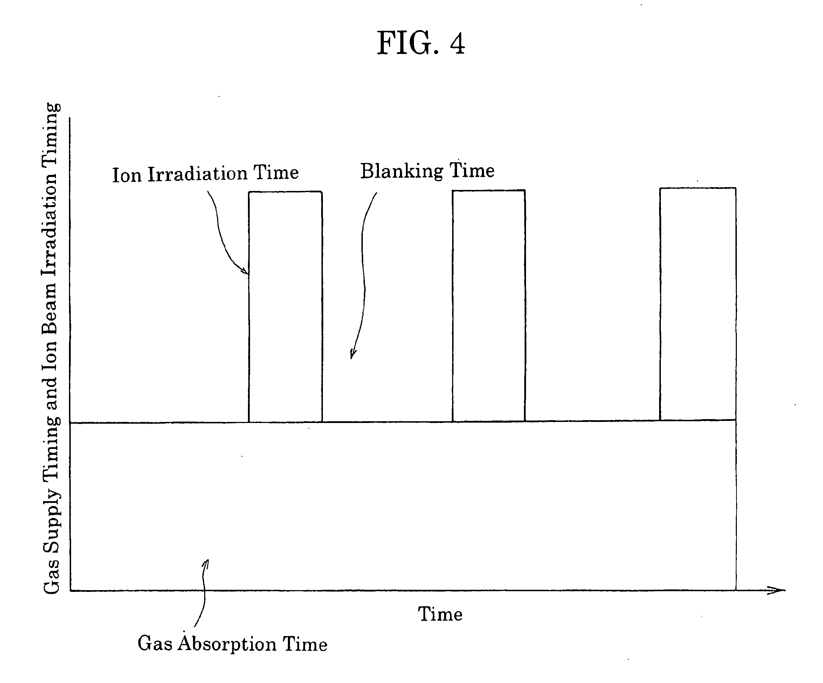

Fig.4 is a diagram showing the time interval of the gas supply.

The illustrated diagram shows an embodiment in which the ion beam is intermittently irradiated while interposing blanking times. In this manner, the source gas concentration in the system can be reduced and the appropriate hardness can be obtained.

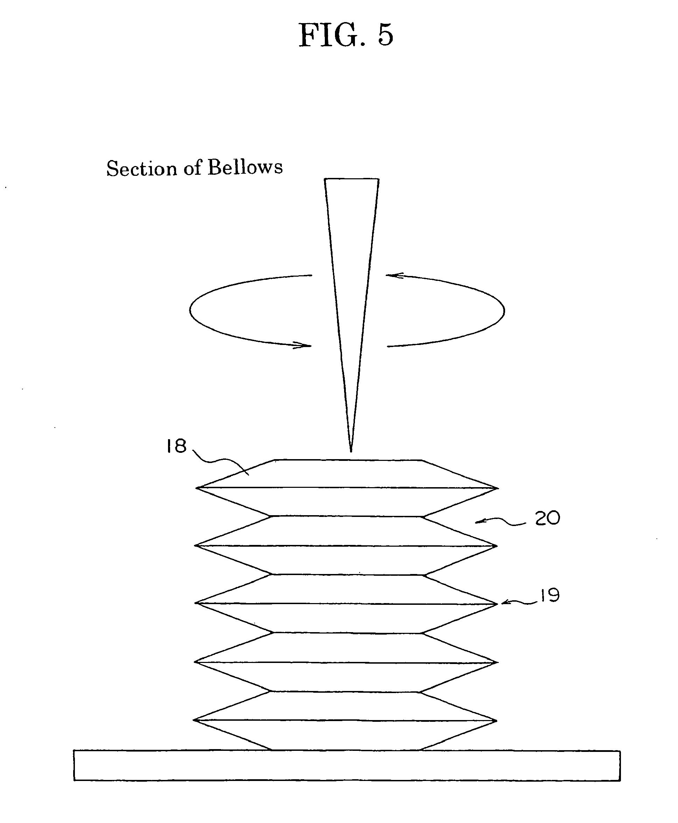

Fig.5 shows an embodiment of DLC in the shape of a bellows in place of the pillar.

A DLC bellows shown in Fig.5 is formed by adhesively bonding a plurality of DLC pieces which have been formed on the substrate and separated. The DLC bellows 18 is tightly bonded at respective edge portions 19 and is softly expanded and contracted at respective expansion and contraction portions 20. Also in this embodiment, the high performance DLC bellows can be obtained by properly establishing the amount of the focused ion beam during the fabrication.

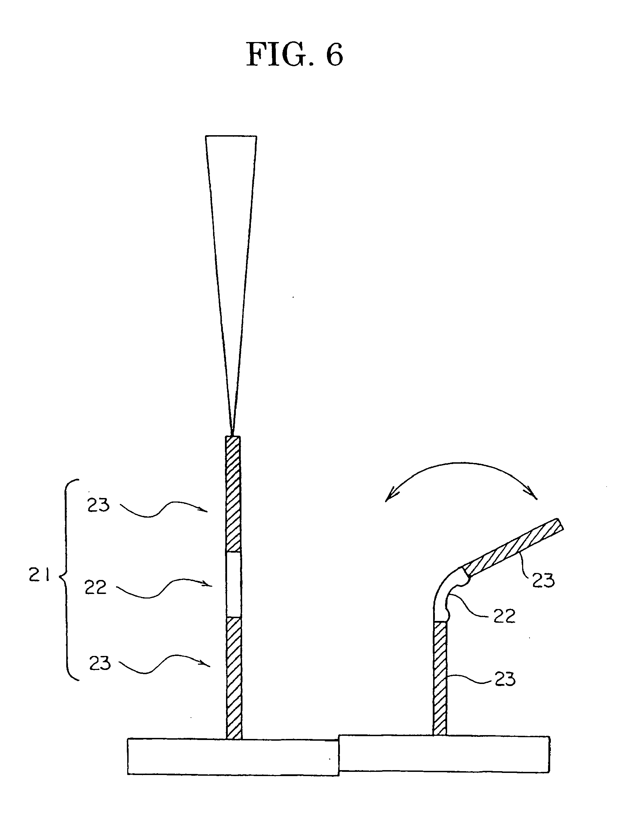

Fig.6 is a diagram showing nano-tweezers fabricated by using DLC pillars.

As shown in Fig.6, a DLC pillar 21 is formed by a soft flexing section 22 and two rigid sections 23 sandwiching the flexing section. The nano-tweezers can be continuously formed by both rigid sections and the middle section which is actually required to be flexural.

### [Examples]

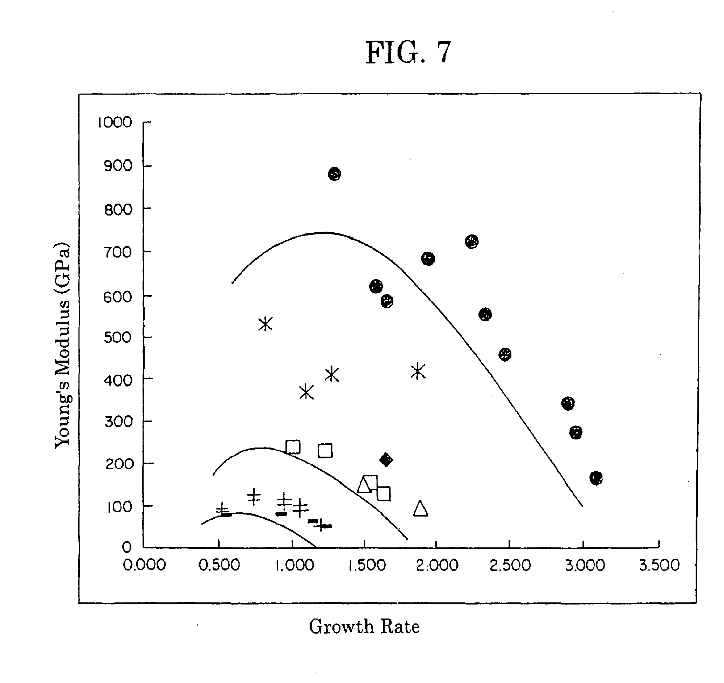

An ultra-thin DLC pillar having a diameter of about 100 nm was grown by irradiating focused ion beam in phenanthrene acting as source gas so that a growth rate was adjusted as shown on the abscissa axis of a graph of Fig.7 in which the relation between the growth rate of the DLC pillar and the Young's modulus is shown. The partial pressure of the source gas was adjusted with ion beam of 1 pA (this depends on the aerodynamic volume displacement of an apparatus, and each apparatus has an inherent value), and the growth rate of the DLC pillar from 1.2 to 2.0 µm/min. provided the DLC pillar having the Young's modulus from 700 to 900 GPa.

In Fig.7, ● indicates the case DLCs were formed at the beam current of 1 pA, □ indicates the case DLCs were formed at the beam current of 0.3 pA and + indicates DLCs having been formed at the beam current of 0.1 pA.

The hardnesses obtained were over about 600 GPa which is that of tungsten carbide (WC) and were near to 1220 GPa which is that of natural diamond, and the DLC structure having the extreme hardness could be easily obtained.

Conversely, when the growth rate was adjusted to be about 3 µ m/min. by controlling the partial pressure of the gas, the Young's modulus was about 200 GPa. The higher growth rate provided the Young's modulus of 80 GPa which is similar to that of aluminum or gold. In this manner, the hardness of the DLC structure fabricated by FIB CVD can be controlled in a significantly broad span.

Since the above embodiments are described only by way of examples, the present invention shall not be restricted to the above embodiments, and various modifications or alterations can be easily made therefrom by those skilled in the art without departing from the scope of the present invention.

## Claims

1. A method for forming an elastic diamond-like carbon structure having ultra high strength by using a chemical decomposition reaction of hydrocarbon gas generated by a focused ion beam, **characterized in that:**
an amount of irradiation of said focused ion beam is controlled based on ion beam current of 0.1 to 10 pico-ampereand
a growth rate of the diamond-like carbon structure is controlled from 1.2 to 2.0 micrometers per minute.

2. The method for forming an elastic carbon structure having ultra high strength according to claim 1, wherein said focused ion beam is irradiated with an interval timing wherein an irradiation for a specified time length and a stop of irradiation for a specified time interval are iterated.

3. The method for forming an elastic carbon structure having ultra high strength according to claim 1, wherein a gas supply system in a focused ion beam apparatus for irradiating said focused ion beam is provided with a plurality of gas nozzles disposed to oppose the position irradiated by said ion beam.

4. The method for forming an elastic carbon structure having ultra high strength according to claim 3, wherein said gas nozzles are disposed so that tips of said nozzles are 500 micrometers or less apart from the substrate.

5. The method for forming an elastic carbon structure having ultra high strength according to claim 1, wherein a gas supply system in a focused ion beam apparatus for irradiating said focused ion beam is provided with a gas nozzle disposed to oppose the position irradiated by said beam and a gas reflection wall disposed around the position irradiated by said beam.

6. The method for forming an elastic carbon structure having ultra high strength according to claim 5, wherein said gas reflection wall has a height designed substantially equal to the distance between the substrate and said gas nozzle.

7. The method for forming an elastic carbon structure having ultra high strength according to claim 5, wherein said gas refection wall has a width designed substantially equal to the distance between the substrate and said gas nozzle.

8. The method for forming an elastic carbon structure having ultra high strength according to claim 5, wherein said gas reflection wall has a shape designed so as to surround the substrate.

## Patentansprüche

1. Verfahren zum Bilden einer elastischen diamantartigen Kohlenstoffstruktur mit ultrahoher Festigkeit durch Verwendung einer von einem fokussierten Ionenstrahl ausgelösten chemischen Zersetzungsreaktion von Kohlenwasserstoffgas, **dadurch gekennzeichnet, dass:**
die Strahlungsmenge des fokussierten Ionenstrahls basierend auf einem Ionenstrahlstrom von 0,1 bis 10 Pikoampere gesteuert wird und
die Wachstumsrate der diamantartigen Kohlenstoffstruktur auf 1,2 bis 2,0 Mikrometer pro Minute gesteuert wird.

2. Verfahren zum Bilden einer elastischen Kohlenstoffstruktur mit ultrahoher Festigkeit nach Anspruch 1, wobei der fokussierte Ionenstrahl mit einem Intervalltakt ausgestrahlt wird, in dem eine Bestrahlung für eine bestimmte Zeitlänge und ein Unterbrechen der Bestrahlung für ein bestimmtes Zeitintervall wiederholt werden.

3. Verfahren zum Bilden einer elastischen Kohlenstoffstruktur mit ultrahoher Festigkeit nach Anspruch 1, wobei ein Gaszufuhrsystem in einer Vorrichtung mit fokussiertem Ionenstrahl zum Ausstrahlen des fokussierten Ionenstrahls mit einer Mehrzahl Gasdüsen versehen ist, die so angeordnet sind, dass sie der von dem Ionenstrahl bestrahlten Position gegenüberliegen.

4. Verfahren zum Bilden einer elastischen Kohlenstoffstruktur mit ultrahoher Festigkeit nach Anspruch 3, wobei die Gasdüsen so angeordnet sind, dass Spitzen der Düsen 500 Mikrometer oder weniger von dem Substrat entfernt sind.

5. Verfahren zum Bilden einer elastischen Kohlenstoffstruktur mit ultrahoher Festigkeit nach Anspruch 1, wobei ein Gaszufuhrsystem in einer Vorrichtung mit fokussiertem Ionenstrahl zum Ausstrahlen des fokussierten Ionenstrahls mit einer Gasdüse versehen ist, die so angeordnet sind, dass sie der von dem Ionenstrahl bestrahlten Position und einer Gasabprallwand gegenüberliegt, die um die von dem Strahl bestrahlten Position herum angeordnet ist.

6. Verfahren zum Bilden einer elastischen Kohlenstoffstruktur mit ultrahoher Festigkeit nach Anspruch 5, wobei die Gasabprallwand eine Höhe aufweist, die so ausgebildet ist, dass sie im Wesentlichen gleich dem Abstand zwischen dem Substrat und der Gasdüse ist.

7. Verfahren zum Bilden einer elastischen Kohlenstoffstruktur mit ultrahoher Festigkeit nach Anspruch 5, wobei die Gasabprallwand eine Breite aufweist, die so ausgebildet ist, dass sie im Wesentlichen gleich dem Abstand zwischen dem Substrat und der Gasdüse ist.

8. Verfahren zum Bilden einer elastischen Kohlenstoffstruktur mit ultrahoher Festigkeit nach Anspruch 5, wobei die Gasabprallwand eine Form aufweist, die so ausgebildet ist, dass sie das Substrat umgibt.

## Revendications

1. Procédé de formation d'une structure de carbone de type diamant élastique à résistance ultra-élevée au moyen d'une réaction de décomposition chimique d'un hydrocarbure gazeux généré par un faisceau d'ions focalisé, **caractérisé en ce que :**
une quantité d'irradiation dudit faisceau d'ions focalisé est contrôlée sur la base d'un courant de faisceau d'ions de 0,1 à 10 pico-ampères, et
une vitesse de croissance de la structure de carbone de type diamant est contrôlée entre 1,2 et 2,0 micromètres par minute.

2. Procédé de formation d'une structure de carbone élastique à résistance ultra-élevée selon la revendication 1, dans lequel ledit faisceau d'ions focalisé est irradié avec un rythme d'intervalle dans lequel une irradiation pendant une durée spécifiée et un arrêt de l'irradiation pendant un intervalle de temps spécifié sont répétés.

3. Procédé de formation d'une structure de carbone élastique à résistance ultra-élevée selon la revendication 1, dans lequel un système d'alimentation en gaz dans un appareil à faisceau d'ions focalisé pour irradier ledit faisceau d'ions focalisé est pourvu d'une pluralité de buses à gaz disposées d'un côté opposé à la position irradiée par ledit faisceau d'ions.

4. Procédé de formation d'une structure de carbone élastique à résistance ultra-élevée selon la revendication 3, dans lequel lesdites buses à gaz sont disposées de manière à ce que lesdites extrémités des buses soient situées à 500 micromètres ou moins du substrat.

5. Procédé de formation d'une structure de carbone élastique à résistance ultra-élevée selon la revendication 1, dans lequel un système d'alimentation en gaz dans un appareil à faisceau d'ions focalisé pour irradier ledit faisceau d'ions focalisé est pourvu d'une buse à gaz disposée d'un côté opposé à la position irradiée par ledit faisceau et une paroi de réflexion de gaz est disposée autour de la position irradiée pas ledit faisceau.

6. Procédé de formation d'une structure de carbone élastique à résistance ultra-élevée selon la revendication 5, dans lequel ladite paroi de réflexion de gaz a une hauteur qui est conçue pour être sensiblement égale à la distance entre le substrat et ladite buse à gaz.

7. Procédé de formation d'une structure de carbone élastique à résistance ultra-élevée selon la revendication 5, dans lequel ladite paroi de réflexion de gaz a une largeur qui est conçue pour être sensiblement égale à la distance entre le substrat et ladite buse à gaz.

8. Procédé de formation d'une structure de carbone élastique à résistance ultra-élevée selon la revendication 5, dans lequel ladite paroi de réflexion de gaz a une forme qui est conçue pour permettre d'entourer le substrat.
